# EUROPEAN PATENT APPLICATION

(11) **EP 3 962 246 A1**
(43) Date of publication of application: **02.03.2022**
(21) Application number: 20193302.5
(22) Date of filing: 28.08.2020
(51) Int. Cl.: H05K 3/34, H01H 69/02

(54) **SOLDERING METHOD AND DEVICE**

(71) Applicant: Unitechnologies SA, 3238 Gals (CH)
(72) Inventor: Gilliard, Mirko, 2000 Neuchâtel (CH); Vuillet, Olivier, 25000 Besançon (FR); Sibilia, Alessandro, 2000 Neuchâtel (CH)
(74) Representative: AMMANN PATENTANWÄLTE AG

(57) **Abstract**

A soldering head (1), preferably for automated soldering, comprises at least two soldering irons (11) inclined to each other in operational mode. The distance between the tips of the soldering iron (11) is adjustable, preferably by actuators (9), so that they can be closely attached to the objects to be connected by soldering. In particular the soldering irons (11) are attached from opposite faces of an object (e.g. wire (37), component lead (25)) to be connected to a metallic surface (27, 39).

## Description

The present invention is related to a method for soldering a wire to a metallic surface according to the preamble of claim 1 and to a device for executing the method.

Soldering of wires using a soldering iron (or soldering tip) is still needed to connect electrically and mechanically electric and electronic components to circuit boards or other metallic surfaces, where the components have connecting wires. A well-known objective consists in heating the soldering zone to the soldering temperature so that the intermetallic connection is created, and to keep the thermic impact on the environment, in particular the (electronic) component, at a supportable, low level. Furthermore, the soldering should be performed in short time requiring a powerful and hot soldering iron which increases the risk of a thermic overload.

Therefore, it is an object of the present invention to propose a method allowing faster soldering with reduced risk of overheating the soldering point and its environment.

Such a method is defined by claim 1. The further claims define preferred execution manners and a soldering head for executing the method.

Accordingly, a main aspect is to use at least two, and preferably exactly two, soldering irons to heat the soldering point, i.e. the area where a wire is brought as near as possible to, preferably in contact with, a metallic surface so that the wire and the surface can be interconnected by a soldering joint.

Soldering by more than one soldering iron has already been considered, e.g. in DE-A-1809834 but with the aim to create two or more soldered joints at the same time. Accordingly, the soldering irons are arranged in a given distance from each other and operate each on an individual separate soldering point.

The invention will be further described by a preferred exemplary embodiment with reference to the Figures:
- Fig. 1: Side view on the soldering head, soldering irons projected;
- Fig. 2 a/b: Illustration of the soldering process: soldering of a component lead to a plated-through hole, top view.
- Fig. 3 a/b: Illustration of the soldering process of Fig. 3, side view,
- Fig. 4 a/b: Illustration of the soldering process: soldering of a (copper) wire to a metallic plate, top view.

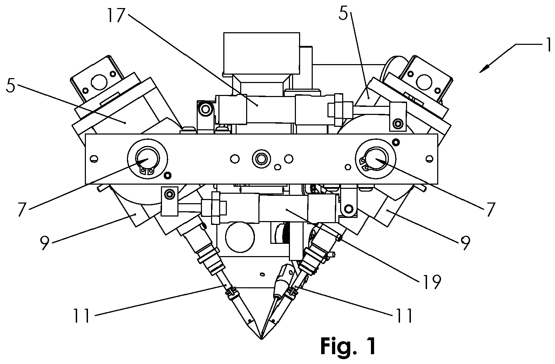

The soldering head 1 comprises a frame 3, in which two soldering units 5 are held pivotably around axes 7. Each soldering unit 5 comprises a pneumatic drive 9 which is arranged to move a soldering iron 11 from an upper or wait position to a lower or working position. Fig. 1 shows the soldering head 1 with the soldering irons 11 in the working position. Each soldering iron is provided with a heating as usual, preferably an electrical heating.

The pneumatic drives are each double-acting, i.e. capable to move the soldering iron actively forward and backward, in order to achieve a fast movement of the soldering irons in both directions.

The coupling between pneumatic drive 9 and soldering iron 11 is axially of variable length and comprises a spring element to keep the coupling at a maximal extension equivalent to a maximal protrusion of the soldering iron 11 in the working position. The maximum extension of the coupling is chosen so that in working position, the two irons just touch each other at most, yet it is avoided that they exert a force on each other. If, however, the soldering irons 11 are in contact with a soldering point, the irons stop once they touch the object to be soldered. The remaining fraction of the stroke of the pneumatic drives 9 is absorbed by compressing the spring element in the coupling and reducing the length of the coupling. Such spring loaded couplings of variable axial length are known in the art, and a detailed description is waived therefore.

The soldering head furthermore comprises a solder supply unit 15 which provides the solder to the solder point.

In working condition, the axial direction of the soldering unit, i.e. the directions in which the pneumatic driver 9 move the soldering irons, are symmetrically inclined with respect to each other by about 90 °, so that the soldering iron tips are directed towards each other, yet not aligned.

Each soldering unit 5 is held in this position by a double-action pneumatic actuator 17, 19 which allows rotating the iron around axis 7. The other position with the soldering units 5 aligned vertically and in parallel to each other is a cleaning or maintenance position (not shown). Both soldering units 5 can rotate independently but are usually activated at the same time to switch between working and maintenance position.

The stroke of the pneumatic drives 9 is for example 5 to 20 mm, preferably about 7 mm. The spring loaded coupling is capable to compensate 50% to 80% of the stroke, e.g. about 5 mm for a stroke of 7 mm.

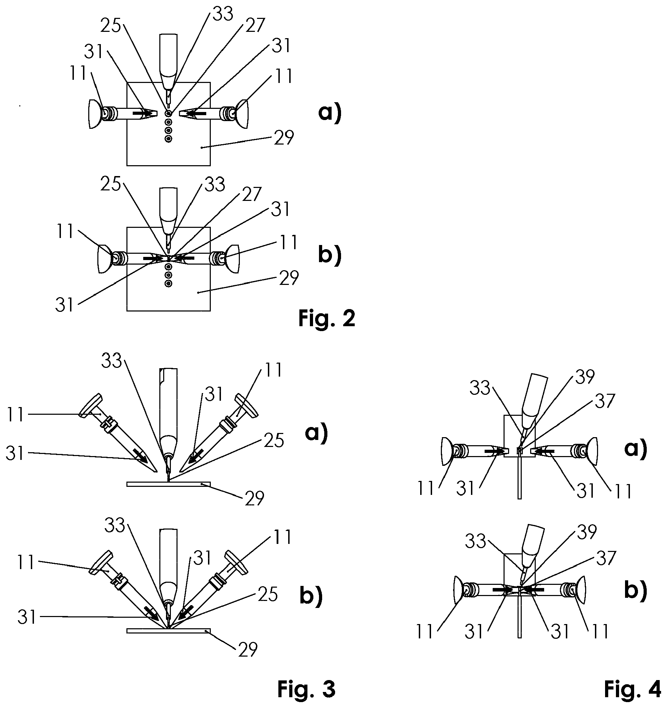

The soldering process using the soldering head 1 is illustrated in Figs. 2 to 4. Figs. 2 and 3 show soldering a through-hole lead 25 of an electronic component (not shown) with the soldering pad 27 of a PCB (printed circuit board) 29. The soldering head 1 is moved over the soldering pad 27 so that the soldering irons 11 are positioned to the right and left of the lead 25 (Figs. 2a, 3a).

The pneumatic drives 9 are activated and the tips of the soldering irons move downward and toward each other as symbolized by arrows 31 until they hit the lead (or pin) 25 or the surface of the PCB, optimally both (Figs. 2b, 3b). The exceeding forward stroke of the pneumatic drives 9 is compensated by the spring element of the coupling. The soldering irons 11 heat the soldering point, i.e. the soldering pad 27 and the lead 25. The solder supply unit 15 supplies solder 33 which melts immediately and forms a solder joint of lead 25 and soldering pad 27. The irons 11 are retracted into the wait position, and the head 1 is moved to the next (soldering) position.

In using two irons simultaneously, a significant reduction of the soldering time per soldering point is observed: For example, time for soldering a pin of a through-hole component could be lowered from 30 seconds (using a single soldering iron) to 10 seconds using two soldering irons according to the invention.

Fig. 4 shows the soldering of a wire 37 to a metal plate 39. The process steps are substantially the same as explained above and illustrated in an analogous manner in Fig. 4a and b. Whereas soldering using one soldering iron took 6 seconds, soldering using two soldering irons took only 2 seconds.

On the basis of the experimental results a general reduction of soldering time to 1/2 or even 1/3 may be expected, so a significantly increased performance in soldering, in particular in automated soldering. It is supposes that this surprisingly high acceleration is a consequence of better heat transfer to the parts to be soldered in using two soldering irons. It may as well increase efficiency that the soldering irons contact these parts from opposing sides.

The obtained significant and surprising reduction in soldering time allows increasing the production rate accordingly. The soldering head 1 is particularly suited to be integrated in a system for automated soldering. In this respect, it has been found that an exact position of the metallic surface is important, in particular its distance from the soldering head, so that the tips of the soldering irons are exactly placed and in contact with the surface as well as with the object (lead of a component, wire etc.) which is to be connected to the surface, so that a low thermal resistance between soldering iron, metallic surface and object to be soldered results. This exact positioning may be attained by mechanical constructional means so that the distance between soldering head and metallic surface is determined in before and therefore known to a controller which controls the movement of the soldering with respect to the metallic surface.

Another possibility is to provide a precision distance sensing means, which may be optical, acoustical, mechanical or by another measuring principle. Based on the distance values obtained by such a sensor, the distance between metallic surface and soldering head can be continually adjusted.

Starting from the preceding description of an exemplary embodiment, the one skilled in the art is able to conceive variants and extensions without leaving the scope of the invention which is defined by the claims. The following modifications are conceivable, for example:
- More than two soldering irons are present, e.g. three.
- The coupling of variable length allows a variation of its length of up to 10 mm usually. A length up to 50 mm is conceivable. The variation of length of the coupling is limited by the stroke of the pneumatic actuators. Usually, it is at most 50 %, preferably at most 60 % and more preferably at most 70 % of the actuator's stroke length.
- The stroke of the pneumatic actuators of the soldering irons is usually up to 20 mm. A stroke up to 100 mm is conceivable, preferably in combination with a precise guidance.
- The tips of the soldering irons may have another shape instead of chisel, e.g. conical, point, bevel.
- The angle between soldering irons is from 20 ° to 160 °, preferable 60 ° to 120 °, more preferably 80 ° to 100 °, and most preferably about 90 °, possibly with a tolerance of ± 2°.

## Claims

1. Method of soldering a metallic wire (25, 37) to a metallic surface (29, 30), comprising the step that the wire and the surface are brought close to each other, preferably in contact to each other, **characterized by** the further steps:
- at least two soldering irons (11) are moved each toward the wire and the metallic surface in an arrangement that the wire is located between the soldering irons, and
- heating the wire and the metallic surface by the soldering irons simultaneously in order to reduce the soldering time.

2. The method of claim 1, **characterized in that** the soldering irons (11) are moved towards wire (25, 37) and metallic surface (29, 30) by actuators (9).

3. The method according to claim 2, **characterized in that** the soldering irons (11) are mechanically coupled each to an actuator (9) by a coupling having a length which can be reversibly reduced against the force of an elastic element, in particular a spring elastic element..

4. The soldering method according to one of claims 1 to 3, **characterized in that** the soldering irons (11) are moved towards wire 25, 37) and metallic surface (29, 30) in an angle of 10° to 90 °, preferably in an angle of 30 ° to 60 °, more preferably in an angle of 40° to 50°, and most preferably in an angle of 44° to 46°, with respect to an orthogonal direction on the metallic surface

5. The soldering method according to one of claims 1 to 4, **characterized in that** for maintenance purposes, in particular cleaning, the soldering irons (9) are pivoted from the working position in a maintenance orientation where the soldering irons are aligned substantially in parallel.

6. A soldering head (1) for executing the soldering method according to one of claims 1 to 5 **characterized in that** it comprises at least two, preferably two, soldering units (5) comprising a soldering iron (11) having a heated end and extending in an axial direction, wherein the axial directions are inclined with respect to each other by 20° to 160 °, preferably by 60 ° to 120 °, more preferably by 80 ° to 100 °, even more preferably by 88 ° to 92 °, and most preferably by about 90 °, with the heated ends being directed toward each other.

7. The soldering head (1) according to claim 6, **characterized in that** each soldering unit (5) comprises an actuator (9) operably connected by a coupling with the soldering iron and capable to move the soldering iron (11) in the axial direction by a stroke length, the coupling having a variable length and comprising an elastic element arranged that it is compressed when the length of the coupling reduced, so that the soldering iron can be stopped by touching the metallic surface (29, 39) or the wire (25, 27) while the actuator (9) is moving it forward along its axial direction while reducing the length of the coupling.

8. The soldering head (1) according to one of claims 6 to 7, **characterized in that** the actuators (9) are pneumatic drives, in particularly double-acting pneumatic drives.

9. The soldering head (1) according to one of claims 6 to 8, **characterized in that** the stroke length of the pneumatic drives (9) is at most 100 mm, preferably at most 20 mm, more preferably at most 10 mm.

10. The soldering head (1) according to one of claims 7 to 9, **characterized in that** the difference between maximal and minimal value of the variable length of the coupling is at most 50 mm, preferably at most 10 mm, and more preferably at most 5 mm.

11. The soldering head (1) according to one of claims 7 to 9, **characterized in that** the difference between maximal and minimal value of the variable length of the coupling is at least 50 %, preferably at least 60 %, more preferably at least 70 %, and most preferably at most 80 % of the stroke length.

12. The soldering head (1) according to one of claims 6 to 11, **characterized in that** the soldering irons (9) are pivotable with respect to each other in order to be movable from the orientation inclined relatively to each other to a substantially parallel orientation for maintenance, in particular for cleaning.

13. A system for automatic soldering comprising the soldering head (1) according to one of claims 6 to 11, **characterized in that** it further comprises a control unit for operating the soldering head and moving it to the locations where a wire is to be soldered to a metallic surface.
